# FASCICULE DE BREVET EUROPEEN

(11) **EP 1 975 995 B1**
(45) Date de publication et mention de la délivrance du brevet: **15.06.2011**
(21) Numéro de dépôt: 08300149.5
(22) Date de dépôt: 20.03.2008
(51) Int. Cl.: H01L 21/60, H01L 23/498

(54) **Procédé de soudure de deux éléments entre eux au moyen d'un matériau de brasure**
Verfahren zum Verschweißen von zwei Teilen mit Hilfe eines Lötmaterials
Method of welding two elements together by means of a brazing material

(30) Priorité: 26.03.2007 FR 0754026
(43) Date de publication de la demande: 01.10.2008
(73) Titulaire: Commissariat à l'Énergie Atomique et aux Énergies Alternatives, 75015 Paris (FR)
(72) Inventeur: Marion, François, 38950 Saint Martin le Vinoux (FR)
(74) Mandataire: Vuillermoz, Bruno

(56) Documents cités:
- FR-A- 2 890 235
- US-A1- 2006 030 075

## Description

### DOMAINE TECHNIQUE DE L'INVENTION

La présente invention concerne le domaine de la micro électronique et plus particulièrement celui des techniques d'hybridation par billes de composant hétérogènes, également appelées billes de brasure. Elle se rattache donc au domaine général des microcomposants, plus classiquement dénommés puces électroniques, mais est également susceptible de s'appliquer aux micro-capteurs, micro-actuateurs, tels que les *MEMS* (selon l'expression anglo-saxonne « *Micro Electro Mecanicals Systems* »), également aux composants optoélectroniques, type VCSEL (pour l'expression anglo-saxonne « *Vertical Cavity Semiconducteur Emitting Laser* ») etc...

Au sens de la présente invention, on entend par composants un capteur électronique, tels qu'une puce électronique, un support de circuit électrique ou électronique, voire un composant mécanique passif du type capot de protection, voire même un capteur de grandeur physique.

### ETAT ANTERIEUR DE LA TECHNIQUE

Les microcomposants dont il est question dans la présente invention sont classiquement déposés sur un substrat de nature appropriée, par exemple de type semi-conducteur (silicium monocristallin, saphir, etc...) pour des composants électroniques.

Ces substrats sont munis de pistes conductrices de l'électricité, par exemple réalisées en aluminium, qui rayonnent à partir du microcomposant en direction de la périphérie du substrat, afin de permettre, outre l'alimentation électrique du composant, le cas échéant requise, également et surtout le traitement et l'exploitation des signaux que ledit composant est appelé à générer, voire le pilotage des fonction qu'il incorpore.

Pour assembler différents composants entre eux, l'une des techniques aujourd'hui largement répandue est celle de l'hybridation par billes dites « *Flip Chip* ». Cette technologie consiste succinctement :
- à déposer sur une ou plusieurs surfaces mouillables mises en place sur l'un des composants à assembler le matériau constitutif des billes de soudure une quantité appropriée dudit matériau fusible ;
- puis à munir l'autre composant à hybrider de surfaces mouillables par ledit matériau fusible, lesdites surfaces étant ménagées sensiblement à l'aplomb des surfaces dudit premier composant lorsque le second composant est reporté sur le premier ;
- puis, par élévation de la température, jusqu'à atteindre une température supérieure à la température de fusion du matériau constitutif des billes, à obtenir la fusion de celles-ci jusqu'à aboutir au résultat recherché, à savoir l'hybridation du premier composant sur le second composant, lesdites billes créant un lien mécanique et/ou électrique entre les surfaces mouillables de chacun des composants, l'une au moins desdites surfaces mouillables étant elle-même reliée électriquement aux pistes conductrices ménagées sur ce dernier.

Ainsi, au cours du procédé d'assemblage, le matériau de brasure constitutif des billes adopte la forme d'une bille.

Or, la brasure de l'indium sur une surface mouillable, typiquement réalisée en or, nécessite la mise en oeuvre d'agents désoxydants liquides ou gazeux, également dénommés flux de soudure. Ce flux permet la désoxydation des oxydes natifs présents sur la surface des billes avant soudure.

Par nature, ces flux de soudure sont généralement corrosifs, et après réduction de l'oxyde, sont susceptibles d'attaquer également le coeur du métal de soudure.

Or, l'expérience démontre que cette corrosion indésirable est aggravée par deux configurations particulières :
- un effet pile résultant de la mise en oeuvre de couple de métaux de potentiels électrochimiques différents en présence du flux de soudure, ce dernier faisant fonction d'électrolyte ;
- la durée excessive de contact entre les billes de soudure et le flux.

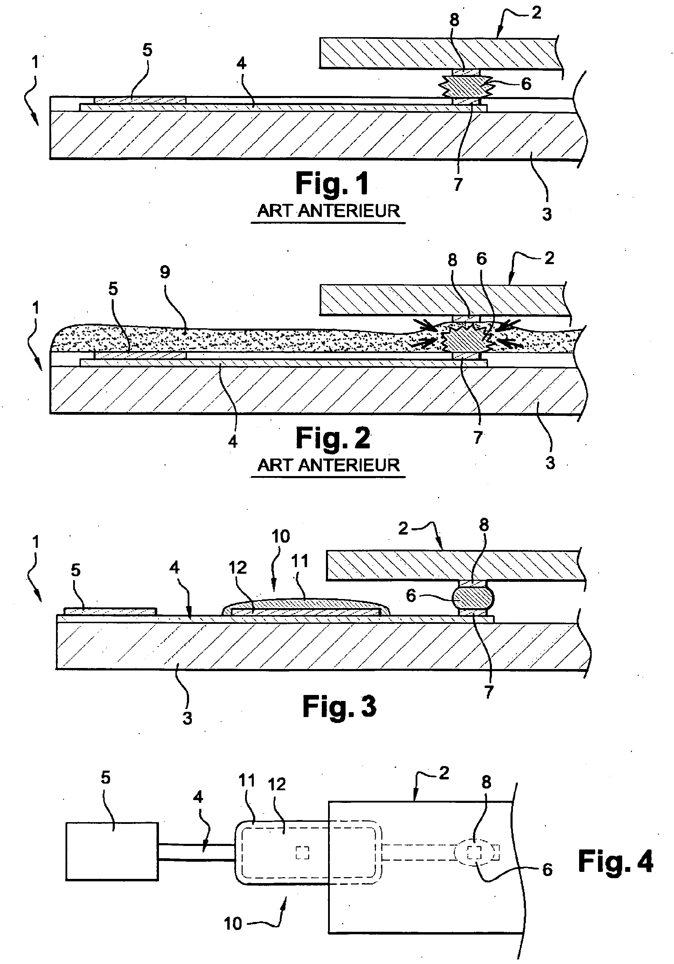

L'effet pile peut être explicité de la manière suivante, en relation avec les figures 1 et 2, décrivant schématiquement une hybridation *Flip Chip* conforme à l'état antérieur de la technique.

On a représenté sur celles-ci un premier composant **1** sur lequel est hybridée une puce **2.**

Le composant **1** comporte un substrat hôte **3,** typiquement réalisé en silicium, sur lequel sont réalisées des pistes conductrices **4,** par exemple réalisées en aluminium. A l'aplomb des zones d'hybridation sont réalisées respectivement sur le substrat **3** et sur la puce à hybrider **2** des surfaces mouillables **7** et **8,** également dénommées UBM selon l'expression anglo-saxonne « *Under Bump Metallization* » et typiquement réalisées en or.

Parallèlement, le composant **1** comporte également une pluralité de plots de connexion externes **5,** également dénommés plots de thermocompression. Ces plots sont en fait constitués d'une surface électriquement conductrice, apte à assurer le relais pour la connexion entre le composant hybridé et l'extérieur. Un tel plot est classiquement une surface métallique sur laquelle est thermocompressé un fil conducteur, typiquement réalisé en or.

Lors de l'hybridation, on étale sur tout le composant **1** après dépôt du matériau de brasure ou de soudure destiné à constituer la bille d'hybridation **6,** un désoxydant **9** (figure 2), qui vient de fait recouvrir à la fois le plot de connexion externe **5** et la bille d'hybridation **6.** Le matériau constituant cette dernière est le plus souvent réalisé en indium, en alliage étain/plomb ou en alliage sans plomb comme AgCuSn.

Ainsi, la couche d'or du plot de connexion externe **5** est reliée par une connexion électrique constituée par la piste aluminium **4** à la bille de soudure **6,** de sorte qu'en raison de la présence du flux de soudure, faisant alors fonction d'électrolyte, il se crée un circuit électrique fermé, engendrant un phénomène électrochimique aboutissant à la réduction du matériau constitutif de la bille d'hybridation, selon les principes bien connus des piles électrochimiques, en raison des potentiels électrochimiques différents des métaux mis en oeuvre.

Ce faisant, on observe la réduction du matériau constitutif de la bille, aboutissant à sa dissolution à tout le moins partielle dans le flux de soudure, et par voie de conséquence à l'altération de l'hybridation recherchée entre la puce **2** et le composant **1.**

Afin de surmonter cet inconvénient, on a tout d'abord proposé soit de recouvrir les plots de connexion externes avec une couche isolante afin de l'isoler du circuit électrochimique précédemment décrit, soit de remplacer l'or du plot de connexion externe par un métal ayant le même potentiel électrochimique que le matériau constitutif de la bille. Cependant, ces deux solutions conduisent à une complexification du procédé de fabrication des circuits hôte, en l'espèce du composant, ne serait-ce qu'en raison de l'adjonction d'une étape supplémentaire aboutissant, outre à une perte en termes de rendements de fabrication, mais également un surcoût de fabrication.

On a également proposé de mettre en oeuvre une protection cathodique :
- soit par dépôt d'une d'anode sacrificielle, et basée sur le principe de la corrosion bimétallique ; un métal est connecté au métal à protéger, ce métal rajouté se corrodant alors en lieu et place de la structure métallique,
- soit par la méthode dite de soutirage de courant, qui nécessite alors la mise en oeuvre d'une alimentation électrique continue. La structure à protéger est dans ce cas connectée à la borne négative d'un générateur de courant continu réglé de manière à maintenir la structure à protéger dans sa zone d'immunité.

Dans un cas comme dans l'autre, la protection cathodique complexifie le procédé de fabrication, outre dans le dernier cas, la gestion des entrées et sorties de signal.

Il convient cependant de souligner que ce problème technique inhérent à la consommation électrochimique du matériau constitutif des billes d'hybridation n'est pas réellement critique si l'hybridation en tant que telle est susceptible d'être réalisée dans un temps réduit.

Cependant, lesdites opérations d'hybridation tendent à devenir systématiquement collectives afin de réduire les coûts de fabrication. Ainsi, on hybride par la technique de refusion collective des composants déposés par centaines, voire par milliers sur un substrat hôte. Les séquences d'hybridation correspondantes peuvent alors durer plusieurs heures et, dans cette hypothèse, ne peuvent plus s'accommoder des phénomènes de corrosion ou de consommation électrochimique précédemment décrits, qui s'amplifient avec le facteur temps.

L'objectif recherché par la présente invention est de s'affranchir de ce double problème technique sans pour autant complexifier le procédé d'hybridation.

### EXPOSE DE L'INVENTION

L'invention vise donc un procédé de soudure ou d'hybridation de deux composants entre eux au moyen d'un matériau de brasure, l'un au moins desdits composants, dénommé premier composant, comportant une ou plusieurs pistes métalliques électriquement conductrices, reliées à autant de plots de connexion externes, procédé qui consiste :
- à réaliser sur les surfaces en regard des composants à souder ou à hybrider une surface de mouillabilité, celle réalisée sur ledit premier composant étant en contact électrique avec une piste métallique conductrice ;
- à déposer sur l'une desdites surfaces de mouillabilité une quantité appropriée de matériau de brasure, propre à constituer un plot de soudure ou d'hybridation ;
- à mettre en contact la surface de mouillabilité de l'autre composant avec ce matériau de brasure ainsi déposé ;
- puis à élever la température de l'enceinte au sein de laquelle sont positionnés les composants à souder ou à hybrider jusqu'à atteindre au moins la température de fusion du matériau de brasure afin d'assurer la soudure ou l'hybridation effective des deux composants entre eux par effet de refusion.

Selon l'invention, ce procédé consiste en outre à déposer sur ledit premier composant et en contact avec ladite piste conductrice une autre quantité dudit matériau de brasure, constituant un plot sacrificiel, de surface de contact avec ledit premier composant plus importante que celle de ladite première quantité destinée à constituer le plot de soudure ou d'hybridation.

En d'autres termes, l'invention consiste à introduire entre le plot de connexion externe et le plot de soudure ou la bille de soudure un, voire plusieurs plots sacrificiels, propres à accumuler la corrosion à leur niveau tout en évitant au plot de soudure dit « utile » de la subir. De fait, ce sont ces plots sacrificiels qui sont réduits lors de l'opération d'hybridation en raison de la mise en oeuvre d'un flux de soudure, en lieu et place du matériau constitutif des plots de soudure ou billes de soudure.

Avantageusement, on induit une résistance électrique plus élevée entre ledit plot sacrificiel et le plot de connexion externe qu'entre ledit plot sacrificiel et le plot de soudure ou d'hybridation.

Dans un mode préférentiel, l'invention permet de réduire quasiment à zéro la différence de potentiel entre les plots sacrificiels et les billes de soudure utiles, de sorte qu'aucun phénomène électrochimique n'est susceptible d'intervenir au niveau desdites billes, en l'absence ou quasi absence de circulation de courant électrique à leur niveau lors de l'opération d'hybridation.

Selon une caractéristique avantageuse de l'invention, la surface du plot sacrificiel en contact avec ledit premier composant est d'au moins dix pourcents (10 %) supérieure à celle du plot ou bille de soudure avant hybridation.

Selon une autre caractéristique de l'invention, et dans la configuration selon laquelle les plots sacrificiels sont en tout ou en partie situés sous la puce à hybrider, la hauteur desdits plots est plus faible que celle du plot de soudure utile.

Selon encore une autre caractéristique de l'invention, et dans la configuration selon laquelle les plots sacrificiels sont en tout ou en partie situés sous la puce à hybrider, lesdits plots viennent en contact avec la face inférieure de la puce à hybrider, au niveau d'un plot de connexion dit plot « mort », non connecté au circuit actif de la puce.

On conçoit de fait que la mise en oeuvre d'un tel plot sacrificiel n'induit pas un niveau de technologie supplémentaire par rapport aux technologies classiques, dans la mesure où le dépôt de ce plot sacrificiel intervient simultanément avec le dépôt de la quantité de matériau destinée à faire fonction de bille de soudure utile.

### BREVE DESCRIPTION DES DESSINS

La manière dont l'invention peut être réalisée et les avantages qui en découlent ressortiront mieux des exemples de réalisation qui suivent, donnés à titre indicatif et non limitatif à l'appui des figures annexées.
Les figures 1 et 2 sont, comme déjà dit, des représentations schématiques du principe d'hybridation selon l'état antérieur de la technique.
Les figures 3 et 4 sont des représentations schématiques respectivement en section transversale et vue du dessus du principe sous-tendant la présente invention.
La figure 5 est une représentation schématique d'une variante de l'invention.
Les figures 6 et 7 sont des représentations schématiques respectivement en section et vue du dessus d'une autre forme de réalisation de l'invention, mettant en oeuvre la technologie semi-conducteur avec des vias.

### DESCRIPTION DETAILLEE DES MODES DE REALISATION DE L'INVENTION

L'invention va donc plus particulièrement être décrite dans son principe en relation avec les figures 3 et 4.

Celles-ci- représentent l'hybridation d'une puce électronique **2** sur un composant électronique **1.** Celui-ci, comme déjà, dit comporte fondamentalement un substrat **3** également dénommé substrat hôte, typiquement réalisé en un matériau semi-conducteur, et notamment en silicium monocristallin. Sur ce substrat **3** sont manégées un certain nombre de pistes électriquement conductrices **4,** destinées à permettre dans le cas présent la transmission des signaux électriques émanant de la puce **2** vers l'extérieur en vue de leur traitement. De fait, ces pistes électriques **4,** par exemple réalisées en aluminium, aboutissent à un ou plusieurs plots de connexion externe.

Traditionnellement, la réalisation de tels plots de connexion externes suppose la mise en oeuvre d'une couche localisée favorisant la conduction électrique et en l'espèce constituée par un fil d'or **5.**

S'agissant de l'hybridation proprement dite, les billes de connectique également dénommées billes utiles sont typiquement réalisées par dépôt d'une quantité de matériau de brasure **6,** et notamment d'indium, au niveau d'une zone de mouillabilité **7,** également réalisée en or, et positionnée en contact avec la piste conductrice **4** au lieu choisi de l'hybridation. La puce **2** comporte également une telle zone de mouillabilité **8,** située sensiblement à l'aplomb de la de la zone de mouillabilité **7** pour des raisons d'alignement de ladite puce sur le composant électronique **1.**

Un premier objectif est atteint en déposant entre le plot de connexion externe **5** et la première bille utile **6** une quantité de matériau de brasure **11,** de même nature que celui constitutif de ladite bille utile **6** sur une surface de mouillabilité **12** également rapportée ou déposée sur la piste conductrice **4.** On réalise ainsi un plot qualifié de sacrificiel **10,** en raison de sa disparition partielle lors de l'opération d'hybridation proprement dite.

La formation de ce plot sacrificiel **10** intervient concomitamment avec la formation de la bille de soudure **6.**

La surface occupée par le plot sacrificiel **10** sur le substrat hote **3** est d'au moins dix pourcents supérieure à celle occupée par le dépôt du matériau de brasure constitutif de la bille d'hybridation utile **6.** On peut bien observer cette différence de surface par exemple sur la figure 4, illustrant une vue du dessus du principe général sous-tendant la présente invention.

Un deuxième objectif visé réside dans la formation d'une résistance électrique entre le plot de connexion externe **5** et le plot sacrificiel **10** supérieure à celle existant entre ledit plot sacrificiel **10** et la bille d'hybridation **6** lorsque l'ensemble est revêtu du flux de soudure.

Il se crée alors une différence de potentiel entre le plot sacrificiel **10** et le plot de connexion externe **5** supérieure à la différence de potentiel entre ledit plot sacrificiel **10** et la bille **6.** Le courant circulant dans ces connexions est alors plus faible, ce qui entraîne une corrosion électrochimique plus faible tant du plot sacrificiel que de la bille « utile », ce qui permet en particulier d'améliorer la durée de vie du composant.

Ainsi, lors de l'étalement du flux de soudure outre de l'opération de montée en température de fusion et de soudure, dont il a été indiqué précédemment qu'elle était susceptible de durer plusieurs heures pour des hybridations multiples, seul, ou quasiment seul le matériau constitutif **11** du plot sacrificiel **10** est susceptible d'être réduit en raison de l'effet pile et dilué dans le flux de soudure. En d'autres termes, la bille d'hybridation utile **6** n'est plus consommée lors de cette opération.

Dans le cas particulier qui peut être nécessité par construction, où la puce à hybrider **2** est relativement proche du plot de connexion externe **5,** le dépôt de matériau **11** constitutif du plot sacrificiel **10** est réalisé de façon à présenter une hauteur inférieure à celle du dépôt du matériau de brasure destiné à constituer la bille d'hybridation **6.**

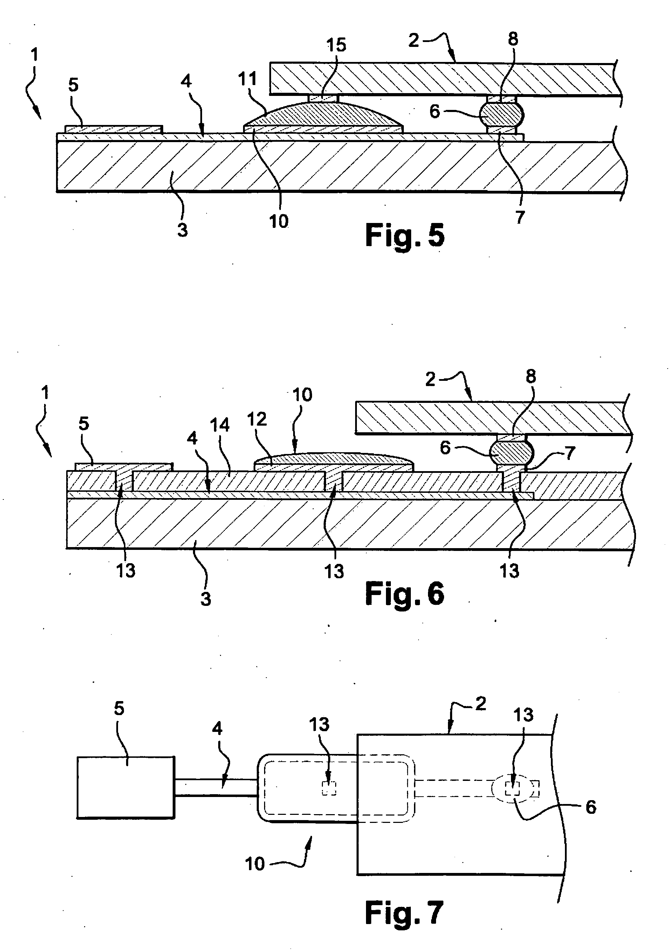

Dans ce même cas particulier, on peut préférer la mise en oeuvre illustrée sur la figure 5. Selon cette forme de réalisation, le plot sacrificiel **10** vient en contact avec la face inférieure de la puce à hybrider **2,** au niveau d'un plot **15,** qualifié de plot « mort », c'est à dire non connecté au circuit actif de ladite puce, contrairement au plot **8,** qui lui est effectivement connecté audit circuit actif.

On conçoit que le procédé d'hybridation n'engendre pas de complexification par rapport à celui de l'état antérieur de la technique et notamment n'implique pas le dépôt d'un niveau supplémentaire d'une couche quelconque puisque, ainsi que déjà rappelé, le dépôt du matériau destiné à constituer le plot sacrificiel **10** est réalisé simultanément au dépôt du même matériau de brasure destiné à constituer les billes d'hybridation utiles **6.** Corollairement, l'alignement des composants en vis-à-vis, notamment face retournée et en l'espèce de la puce **2,** intervient de manière tout à fait classique dans le cadre de la technologie *Flip Chip.*

Lors de la phase de montée en température destinée à aboutir à la fusion des billes, seule la corrosion du plot sacrificiel **10** est activée, mais en revanche les billes d'hybridation utiles **6** ne sont pas affectées. Les billes utiles se soudent au plot métallisé en regard **8** du composant à hybrider, et en l'espèce de la puce **2,** de sorte que tous les composants déposés se soudent simultanément.

Lors de l'étape de refroidissement, le substrat hôte **3** est refroidi, et les résidus du flux de soudure sont nettoyés. Ce faisant, la corrosion ou la consommation des plots sacrificiels s'arrête puisque les phénomènes électrochimiques disparaissent en raison de la suppression du flux.

Dans un certain nombre de configurations, les lignes de connexion du substrat semi-conducteur **3** sont passivées par une couche de passivation **14,** typiquement réalisée en silice ou en nitrure de silicium. On réalise des ouvertures **13** également dénommées vias au sein de cette couche, comblées par un matériau conducteur électrique, afin de connecter électriquement les surfaces de mouillage **7, 12** et le plot de connexion externe **5** aux pistes de connexion **4** (figures 6 et 7). Le procédé de l'invention demeure cependant strictement identique. Là encore, il est mis en oeuvre un plot sacrificiel **10** selon le même processus opératoire que celui décrit en relation avec les figures 3 à 5.

A titre d'application numérique, et en fonction des hypothèses suivantes retenues, on aboutit par exemples aux données suivantes :

| | | |
|---|---|---|
| Nature du métal de connectique (piste conductrice **4**) | : | aluminium |
| Nature du matériau de soudure ou de brasure | : | indium |
| Nature des surfaces de mouillabilité | : | or |
| Nature du plot de thermo compression | : | or |
| Eventuellement couche de passivation | : | silice ou nitrure de silicium |

Dans un premier exemple, la durée de contact du flux de soudure est fixée à deux heures, en raison du nombre relativement réduit de composants hybridés.

| | | |
|---|---|---|
| - plot de connexion externe **5** (de thermo compression) | : | 80 x 100 µm ; |
| - dimensions de la piste de connectiques **4** entre le plot sacrificiel **10** et le plot de thermo compression **5** | : | longueur 20µm, largeur 50µm |
| - dimensions de la piste de connectique **4** entre le plot sacrificiel **10** et la bille utile de soudure **6** | : | longueur 50µm, largeur 10µm |
| - bille de soudure utile **6** | : | diamètre 30µm, hauteur 20 µm |
| - dimensions du plot sacrificiel **10** | : | 50 x 50µm pour une épaisseur de 5 µm |

Lorsque la durée de contact du flux atteint des valeurs supérieures et typiquement huit heures, requis en cas d'hybridation multiple, on augmente alors la taille du plot sacrificiel dans la même configuration à typiquement 100 µm x 100 µm.

Ce faisant, par la mise en oeuvre du procédé conforme à l'invention, on aboutit sans complexification des procédés traditionnels d'hybridation *Flip Chip* à une qualité d'hybridation bien supérieure au regard de l'état antérieur de la technique, puisque les billes d'hybridation mises en oeuvre ne sont plus ou quasiment plus affectées par les phénomènes électrochimiques décrits en préambule. Il devient en outre possible d'augmenter encore le nombre de composants à hybrider sans risque de détérioration de l'hybridation.

La présente invention trouve donc tout naturellement son application dans les domaines d'hybridation classiquement mis en oeuvre tels que notamment :
- le report de type « multi-chip module » sur un banc de silicium, sur un circuit imprimé en céramique ;
- le report collectif *Flip Chip* de circuits de détection, tels que notamment infrarouge, rayon X visibles sur une plaque CMOS ;
- le report collectif *Flip Chip* de circuits optiques, d'émission laser ou de réception sur plaque CMOS ou des bancs optiques en silicium ou autre matériau.

## Revendications

1. Procédé de soudure ou d'hybridation de deux composants (1, 2) entre eux au moyen d'un matériau de brasure, l'un (1) au moins desdits composants, dénommé premier composant, comportant une ou plusieurs pistes métalliques (4) électriquement conductrices, reliées à autant de plots de connexion externes (5), consistant:
- à réaliser sur les surfaces en regard des composants à souder ou à hybrider une surface de mouillabilité (7, 8), celle réalisée sur ledit premier composant (1) étant en contact électrique avec une piste métallique conductrice (4) ;
- à déposer sur l'une desdites surfaces de mouillabilité une quantité appropriée de matériau de brasure, propre à constituer un plot de soudure ou d'hybridation (6) ;
- à déposer un flux de soudure sur la surface dudit premier composant (1) ;
- à mettre en contact la surface de mouillabilité de l'autre composant avec le matériau de brasure ainsi déposé ;
- puis à élever la température de l'enceinte au sein de laquelle sont positionnés les composants à souder ou à hybrider jusqu'à atteindre au moins la température de fusion du matériau de brasure afin d'assurer la soudure ou l'hybridation effective des deux composants entre eux par effet de refusion,
***caractérisé* en ce qu'**il consiste en outre à déposer sur ledit premier composant (1) et en contact avec ladite piste conductrice (4) une autre quantité (11) dudit matériau de brasure, constituant un plot sacrificiel (10) mis en série sur ladite piste métallique (4) entre le plot de connexion externe (5) et le plot de soudure ou d'hybridation (6), et de surface de contact avec ledit premier composant supérieure à celle de ladite première quantité destinée à constituer le plot de soudure ou d'hybridation (6).

2. Procédé de soudure ou d'hybridation de deux composants (1, 2) entre eux au moyen d'un matériau de brasure selon la revendication 1, ***caractérisé* en ce qu'**il consiste à induire une résistance électrique plus élevée entre le plot sacrificiel (10) et le plot de connexion externe (5) qu'entre ledit plot sacrificiel (10) et le plot de soudure ou d'hybridation (6).

3. Procédé de soudure ou d'hybridation de deux composants (1, 2) entre eux au moyen d'un matériau de brasure selon l'une des revendications 1 et 2, ***caractérisé* en ce que** la surface du plot sacrificiel (10) en contact avec ledit premier composant (1) est d'au moins dix pourcents (10 %) supérieure à celle du plot ou bille de soudure (6) avant hybridation.

4. Procédé de soudure ou d'hybridation de deux composants (1, 2) entre eux au moyen d'un matériau de brasure selon l'une des revendications 1 à 3, ***caractérisé* en ce que** le plot sacrificiel (10) est en tout ou en partie situé sous ledit second composant (2), et **en ce que** la hauteur dedit plot étant plus faible que celle du plot de soudure ou d'hybridation (6).

5. Procédé de soudure ou d'hybridation de deux composants (1, 2) entre eux au moyen d'un matériau de brasure selon l'une des revendications 1 à 3, ***caractérisé* en ce que** le plot sacrificiel (10) est en tout ou en partie situé sous ledit second composant (2), et **en ce qu'**il vient en contact avec la face inférieure dudit second composant, au niveau d'un plot de connexion, non connecté au circuit actif dudit second composant.

6. Procédé de soudure ou d'hybridation de deux composants (1, 2) entre eux au moyen d'un matériau de brasure selon l'une des revendications 1 à 5, ***caractérisé* en ce que** le matériau (11) constitutif du plot sacrificiel (10) est déposé sur une surface mouillable (12), elle-même en contact électrique avec la piste conductrice (4).

## Claims

1. A method for soldering or hybridizing two components (1,2) together using a solder material, at least one (1) of said components, called first component, comprising one or more electrically conducting metal tracks (4), connected to as many outer connection dots (5), consisting in:
- preparing, on the opposing surfaces of the components to be welded or hybridized, a wettability surface (7, 8), said surface prepared on said first component (1) being in electrical contact with a conducting metal track (4);
- depositing on one of said wettability surfaces an appropriate quantity of solder material, suitable for constituting a soldering or hybridization dot (6);
- depositing a soldering flux;
- contacting the wettability surface of the other components with the solder material thereby deposited;
- then raising the temperature of the chamber in which the components to be welded or hybridized are positioned, to at least the melting point of the solder material in order to ensure the effective soldering or hybridizing of the two components together by a remelt effect,
***characterized in that*** it further consists in depositing on said first component (1) and in contact with said conducting track (4), another quantity (11) of said solder material, constituting a sacrificial dot (10) placed in series on said metal track (4) between the outer connection dot (5) and the soldering or hybridizing dot (6) and having a contact area with said first component that is higher than that of said first quantity intended to constitute the soldering or hybridizing dot (6).

2. The method for soldering or hybridizing two components (1, 2) together using a solder material, as claimed in claim 1, ***characterized in that*** it consists in inducing a higher electrical resistance between the sacrificial dot (10) and the outer connection dot (5) than between the sacrificial dot (10) and the soldering or hybridizing dot (6).

3. The method for soldering or hybridizing two components (1, 2) together using a solder material, as claimed in either of claims 1 and 2, ***characterized in that*** the area of the sacrificial dot (10) in contact with said first component (1) is at least ten percent (10 %) higher than that of the solder dot or bead (6) before hybridization.

4. The method for soldering or hybridizing two components (1, 2) together using a solder material, as claimed in one of claims 1 to 3, ***characterized in that*** the sacrificial dot (10) is fully or partly located under said second component (2), and **in that** the height of said dot is lower than that of the soldering or hybridizing dot (6).

5. The method for soldering or hybridizing two components (1, 2) together using a solder material, as claimed in one of claims 1 to 3, ***characterized in that*** the sacrificial dot (10) is fully or partly located under said second component (2), and **in that** it comes into contact with the underside of said second component, at a connection dot, unconnected to the active circuit of said second component.

6. The method for soldering or hybridizing two components (1, 2) together using a solder material, as claimed in one of claims 1 to 5, ***characterized in that*** the constituent material (11) of the sacrificial dot (10) is deposited on a wettable surface (12), itself in electrical contact with the conducting track (4).

## Patentansprüche

1. Verfahren, um zwei Bauteile (1, 2) mittels eines Lötmaterials miteinander zu verschweißen oder zu hybridisieren, wobei eines (1) der Bauteile, erstes Bauteil genannt, eine oder mehrere elektrisch leitfähige Leiterbahn/en aus Metall umfasst, die mit ebenso vielen externen Anschlusskontakten (5) verbunden sind, aus Folgendem bestehend:
- auf den den zu verschweißenden oder zu hybridisierenden Bauteilen zugewandten Flächen eine Benetzbarkeitsfläche (7, 8) herzustellen, wobei diejenige, die auf dem ersten Bauteil (1) hergestellt ist, in elektrischem Kontakt mit einer Leiterbahn (4) aus Metall ist;
- auf einer der Benetzbarkeitsflächen eine geeignete Menge an Lötmaterial abzuscheiden, die sich dazu eignet, einen Löt- oder Hybridisierungskontakt (6) zu bilden;
- ein Flussmittel auf der Oberfläche des ersten Bauteils (1) abzuscheiden;
- die Benetzbarkeitsfläche des anderen Bauteils mit dem so abgeschiedenen Lötmaterial in Kontakt zu bringen;
- dann die Temperatur des Behälters, in dessen Innerem die zu verschweißenden oder zu hybridisierenden Bauteile positioniert sind, zu erhöhen, bis sie mindestens die Schmelztemperatur des Lötmaterials erreicht, um das wirksame Verschmelzen oder die wirksame Hybridisierung der beiden Bauteile miteinander durch eine Aufschmelzwirkung sicherzustellen,
**dadurch gekennzeichnet, dass** es außerdem darin besteht, auf dem ersten Bauteil (1) und in Kontakt mit der Leiterbahn (4) eine weitere Menge (11) des Lötmaterials, das einen Opferkontakt (10) bildet, der auf der Leiterbahn (4) aus Metall zwischen dem externen Anschlusskontakt (5) und dem Schweiß- oder Hybridisierungskontakt (6) in Reihe geschaltet wird, und des Flächenmaterials für den Kontakt mit dem ersten Bauteil abzuscheiden, die größer ist als diejenige der ersten Menge, die dazu bestimmt ist, den Schweiß- oder Hybridisierungskontakt (6) zu bilden.

2. Verfahren nach Anspruch 1, um zwei Bauteile (1, 2) mittels eines Lötmaterials miteinander zu verschweißen oder zu hybridisieren, **dadurch gekennzeichnet, dass** es darin besteht, einen höheren elektrischen Widerstand zwischen dem Opferkontakt (10) und dem externen Anschlusskontakt (5) zu induzieren als zwischen dem Opferkontakte (10) und dem Schweiß- oder Hybridisierungskontakt (6).

3. Verfahren nach einem der Ansprüche 1 und 2, um zwei Bauteile (1, 2) mittels eines Lötmaterials miteinander zu verschweißen oder zu hybridisieren, **dadurch gekennzeichnet, dass** die Fläche des Opferkontakts (10), die mit dem ersten Bauteil in Kontakt ist, mindestens zehn Prozent (10%) größer ist als diejenige des Lötkontakts (6) oder der Lötperle vor einer Hybridisierung.

4. Verfahren nach einem der Ansprüche 1 bis 3, um zwei Bauteile (1, 2) mittels eines Lötmaterials miteinander zu verschweißen oder zu hybridisieren, **dadurch gekennzeichnet, dass** sich der Opferkontakt (10) ganz oder teilweise unter dem zweiten Bauteil (2) befindet, und dass die Höhe des Kontakts geringer ist als diejenige des Schweiß- oder Hybridisierungskontakts (6).

5. Verfahren nach einem der Ansprüche 1 bis 3, um zwei Bauteile (1, 2) mittels eines Lötmaterials miteinander zu verschweißen oder zu hybridisieren, **dadurch gekennzeichnet, dass** sich der Opferkontakt (10) ganz oder teilweise unter dem zweiten Bauteil (2) befindet, und dass er mit der Unterseite des zweiten Bauteils im Bereich eines nicht an den aktiven Schaltkreis des zweiten Bauteils angeschlossenen Anschlusskontakts in Kontakt kommt.

6. Verfahren nach einem der Ansprüche 1 bis 5, um zwei Bauteile (1, 2) mittels eines Lötmaterials miteinander zu verschweißen oder zu hybridisieren, **dadurch gekennzeichnet, dass** das Material (11), aus dem der Opferkontakt (10) besteht, auf einer benetzbaren Fläche (12) abgeschieden wird, die ihrerseits mit der Leiterbahn (4) in elektrischem Kontakt ist.
